# EUROPÄISCHE PATENTSCHRIFT

(11) **EP 0 591 262 B1**
(45) Veröffentlichungstag und Bekanntmachung des Hinweises auf die Patenterteilung: **18.10.1995**
(21) Anmeldenummer: 92911711.7
(22) Anmeldetag: 17.06.1992
(51) Int. Cl.: H01L 49/02, H05K 3/46, B32B 31/00

(54) **VERFAHREN ZUM HERSTELLEN EINER FREITRAGENDEN DICKSCHICHTSTRUKTUR**
PROCESS FOR PRODUCING A SELF-SUPPORTING THICK FILM STRUCTURE
PROCEDE POUR LA PRODUCTION D'UNE STRUCTURE A COUCHE EPAISSE AUTOPORTEUSE

(30) Priorität: 28.06.1991 DE 4121390
(43) Veröffentlichungstag der Anmeldung: 13.04.1994
(73) Patentinhaber: ROBERT BOSCH GMBH, 70442 Stuttgart (DE)
(72) Erfinder: ZIMMERMANN, Herbert, D-7141 Freiberg/Heutinghseim (DE); STECHER, Günther, D-7250 Leonberg (DE)
(86) Internationale Anmeldenummer: DE9200498
(87) Internationale Veröffentlichungsnummer: WO9300713

(56) Entgegenhaltungen:
- DE-A- 2 445 086
- DE-A- 3 008 572
- DE-A- 3 015 356

## Beschreibung

### Stand der Technik

Die Erfindung betrifft ein Verfahren zum Herstellen einer freitragenden Dickschichtstruktur auf einem Substrat über einer Aussparung in diesem Substrat.

Dickschichtschaltungen werden vorzugsweise auf keramischen, plättchenförmigen Substraten durch Aufdrucken von Paste hergestellt, deren aktives Material aus Metallpulvern, Glas- bzw. glaskeramischen Pulvern oder aus Mischungen von Glas und Metalloxiden bestehen. Nach dem Brennen dieser aufgedruckten Pasten bei Temperaturen um etwa 850° C entstehen entsprechend den jeweils verwendeten Pasten metallische Schichten, Glas- bzw. glaskeramische Schichten oder Widerstandsschichten. Diese Schichten verbinden sich beim Brennen ganzflächig mit der Substratoberfläche, auf der sie dann eine festhaftende Masse bilden.

Derartige Dickschichtschaltungen finden in vielen Bereichen der Technik Anwendung.

In manchen Fällen ist es notwendig, daß die Schicht mit dem aktiven Material nicht durchgehend auf dem Substrat aufliegt, sondern durch Aufwölbungen Höhlungen entstehen, in denen dann beispielsweise Leiterbahnen, Erhöhungen oder andere Schaltungselemente angeordnet sind. Beispielhaft wird hier auf die DE-OS 30 15 356, die DE-OS 30 08 572 und die DE-OS 28 29 195 verwiesen. Diese geschlossenen Blasen haben allerdings den Nachteil, daß das Luftpolster in der Blase bestimmte nicht gewünschte Wirkungen auf die Schaltung bzw. auf die Schaltelemente hat. So verschlechtert ein noch vorhandener Wärmefluß durch das Luftposter beispielsweise die dynamischen Eigenschaften eines Sensors innerhalb einer geschlossenen Blase. Aus diesem Grunde kann es in manchen Fällen wünschenswert sein, daß zwar eine Höhlung gebildet ist, daß diese Höhlung jedoch nicht allseits geschlossen ist. Hierzu müßte dann in dem Substrat eine Aussparung vorhanden sein, durch welche hindurch die Höhlung offen bleibt, wobei die Höhlung selbst aber von der Dickschichtstruktur überdacht ist.

### Vorteile der Erfindung

Gemäß dem Verfahren nach der vorliegenden Erfindung wird mittels der aktiven Schicht eine Aufwölbung oder eine freitragende Schale über der Aussparung erzeugt, so daß darunter keine geschlossene Blase gebildet ist. Zu diesem Zweck besitzt die Schicht einen thermischen Ausdehnungskoeffizienten, der kleiner ist als derjenige des Substrates. Das bedeutet, daß bei einem Brennen des Substrates mit aufgebrachter Schicht sich das Substrat in die Aussparung weiter ausdehnt, als die aktive Schicht und sich diese damit über der Aussparung aufwölbt.

Für die Schicht wird im übrigen ein brennbarer dielektrischer Werkstoff verwendet, während das Substrat aus Keramik, isoliertem Hochtemperaturstahl oder aus Glas bestehen kann.

Wesentlich ist vor allem der Verfahrensschritt des Herstellens der aktiven Schicht bzw. des Bereitstellens. Es ist verständlich, daß diese Schicht nicht direkt auf das eigentliche Substrat aufgebracht werden kann, da sie ansonsten in die Aussparung durchfallen würde. Erfindungsgemäß wird deshalb ein Hilfssubstrat verwendet, wobei erst nach der Herstellung der Schicht auf dieses Hilfssubstrat das eigentliche Substrat mit der Schicht verbunden wird. Bevorzugt wird auf das Hilfssubstrat zuerst einmal eine Schicht aus Glaskeramik aufgedruckt, wobei in dieser Schicht ein Loch ausgespart bleibt, dessen Zweck weiter unten beschrieben wird. In jedem Fall sollte der Durchmesser des Loches etwa dem halben Durchmesser der später freitragend auszubildenden Dickschichtstruktur entsprechen. Diese Schicht wird dann bei ca. 850° C in Luft eingebrannt.

Nunmehr wird auf die eingebrannte Schicht ein Füllstoff aufgedruckt, welcher beispielsweise Kohle sein kann. Dieser Füllstoff dient vor allem zur Erleichterung der späteren Ablösung der aktiven Schicht, sobald diese mit dem eigentlichen Substrat verbunden ist. Aus diesem Grunde ist auch der Außendurchmesser der Füllstoffschicht bzw. seine Außenkontur größer als diejenige der aktiven Schicht. Diese Füllstoffschicht wird dann bei ebenfalls ca. 850° C in Stickstoff-Atmosphäre niedergesintert.

Nunmehr erfolgt das Aufdrucken der eigentlichen, in Stickstoffatmosphäre brennbaren dielektrischen Schicht, wobei beim Einbrennen dieser Schicht ebenfalls in Stickstoff im Bereich des o.g. Loches eine Ausstülpung erzeugt wird. Die Füllstoffschicht und auch die aktive Schicht sacken in den Bereich des Loches ab. Diese Ausstülpung gewährleistet dann später beim Brand zusammen mit dem eigentlichen Substrat eine eindeutige Aufwölbung der aktiven Schicht weg von der Aussparung.

Bevor nun das eigentliche Substrat mit der aktiven Schicht verbunden wird, erfolgt sein Bedrucken mit einer glashaltigen Paste. Diese glashaltige Paste hat den Zweck, daß eine bessere Verbindung mit der aktiven Schicht erfolgen kann. Nunmehr wird das eigentliche Substrat zusammen mit der Paste auf das Hilfssubstrat mit der aktiven Schicht aufgelegt, wobei die Aussparung in etwa zentrisch zur konkaven Ausstülpung liegt. In diesem Verfahrensstadium kann die Paste naß, getrocknet oder auch gebrannt sein. Danach erfolgt ein Brennen der gesamten Struktur. Bereits beim Brennen löst sich die aktive Schicht durch die Aufwölbung von der Füllstoffschicht ab. Auf diese Weise wird das eigentliche Substrat mit der aktiven Schicht von dem Hilfssubstrat getrennt. Das Hilfssubstrat kann dann wieder verwendet werden zur Herstellung von weiteren freitragenden Dickschichtstrukturen, das Substrat mit der aktiven Schicht wird weiterbearbeitet.

### Zeichnung

Ein Ausführungsbeispiel der Erfindung ist in der Zeichnung dargestellt und in der nachfolgenden Beschreibung näher erläutert; dabei zeigt
- Figur 1: einen Querschnitt durch eine Dickschichtstruktur während des erfindungsgemäßen Herstellungsverfahren;
- Figur 2: einen teilweise dargestellten Querschnitt durch eine Dickschichtstruktur nach Beendigung des erfindungsgemäßen Herstellungsverfahren.

Bei der vorliegenden Erfindung geht es um die Realisierung von freitragenden Dickschichtstrukturen auf einem Substrat 1, welches im Bereich der freitragenden Struktur eine lochförmige Aussparung 2 beliebiger Kontur aufweist. Das Substrat 1 selbst kann beispielsweise aus Keramik, einem isolierten Hochtemperaturstahl oder aus Glas bestehen.

Zur Herstellung dieser freitragenden Dickschichtstruktur wird ein Hilfssubstrat 3 verwendet und mit einer glaskeramischen Schicht 4 bedruckt. Allerdings geschieht das Bedrucken mit der glaskeramischen Schicht 4 so, daß ein Loch 5 mit einem Durchmesser d ausgespart bleibt. Dieser Durchmesser entspricht etwa dem halben Durchmesser der später freitragend auszubildenden Dickschichtstruktur.

Als nächster Verfahrensschritt wird nunmehr die glaskeramische Schicht 4 bei etwa 850° C in Luft eingebrannt, wie dies in der Dickschicht-Technologie üblich ist.

Danach wird auf die glaskeramische Schicht 4 ein geeigneter Füllstoff 6, beispielsweise Kohle, gedruckt. Der Außendurchmesser dₐ dieser Füllstoffschicht 6 ist auf jeden Fall größer als derjenige einer Schicht 7 für die freitragende Struktur. Vor dem Aufbringen der Schicht 7 wird auch die Kohleschicht als Füllstoffschicht bei 850° C in Stickstoff-Atmosphäre niedergesintert.

Danach erfolgt nunmehr das Aufbringen der Schicht 7 für die freitragende Dickschichtstruktur. Diese Schicht 7 besteht aus einer in Stickstoff-Atmosphäre brennbaren dielektrischen Substanz und wird auf den Füllstoff 6 aufgedruckt. Dabei dürfen ihre Außenkonturen diejenigen des Füllstoffes 6 nicht überschreiten. Nach dem Einbrennen in Stickstoff entsteht in der Schicht 7 eine konkave Ausstülpung 8.

Getrennt von diesem Schichtaufbau wird das mit der lochförmigen Aussparung 2 versehene Substrat 1 z.B. kreisringförmig mit einer glashaltigen Paste 9 bedruckt. Das Substrat 1 wird dann mit der Paste 9, welche noch naß, bereits getrocknet oder gebrannt sein kann, auf das Hilfssubstrat 3 mit seinen Beschichtungen so aufgelegt, daß die lochförmige Aussparung 2 in etwa zentrisch zur konkaven Ausstülpung 8 zu liegen kommt.

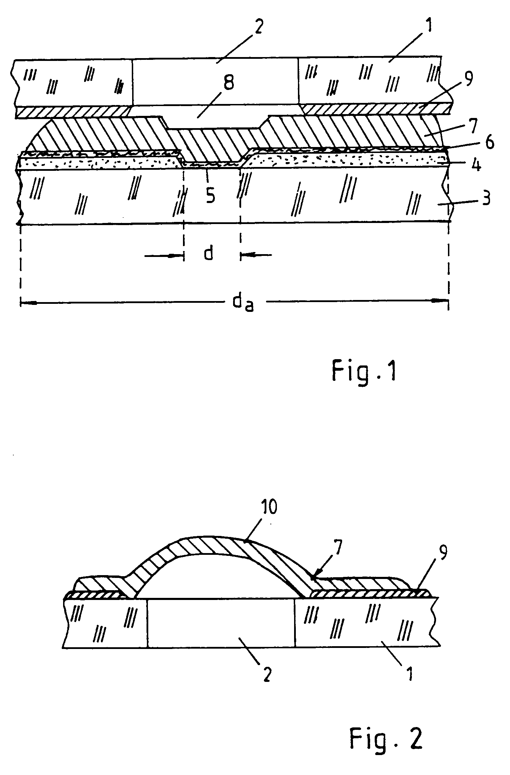

Während dem nachfolgenden Brand bei etwa 850° C in Luft verbindet sich die Schicht 7 mit der glashaltigen Paste 9 und damit mit dem Substrat 1 und bildet über der Aussparung 2 eine freitragende Schale 10, wie dies in Figur 2 angedeutet ist. Diese freitragende Schale 10 als Aufwölbung entsteht dadurch, daß der thermische Ausdehnungskoeffizient der Schicht 7 kleiner als derjenige des Substrates 1 ist. Durch die Ausstülpung 8 wird nach dem Brand eine eindeutige Aufwölbung weg von der lochförmigen Aussparung 2 erzeugt.

Das Substrat 1 mit der freitragenden Schale 10 bzw. Schicht 7 kann nun weiter bearbeitet werden. Das Hilfssubstrat 3 mit der Schicht 4 dagegen kann wieder verwendet werden, beispielsweise zur Herstellung einer weiteren freitragenden Dickschichtstruktur.

## Patentansprüche

1. Verfahren zum Herstellen einer Dickschichtstruktur auf einem Substrat (1) über einer Aussparung (2) in diesem Substrat (1), wobei die aktive Schicht (7) zuerst auf ein Hilfssubstrat (3, 4, 6) aufgebracht und dann mit dem Substrat (1) durch Brennen verbunden wird und wobei die aktive Schicht (7) einen thermischen Ausdehnungskoeffizienten aufweist, der kleiner als derjenige des Substrates (1) ist, so daß über der Aussparung (2) eine freitragende Dickschichtstruktur (10) entsteht.

2. Verfahren nach Anspruch 1, dadurch gekennzeichnet, daß für die aktive Schicht (7) ein brennbarer dielektrischer Werkstoff verwendet wird, während das Substrat (1) aus Keramik, isoliertem Hochtemperaturstahl oder Glas besteht.

3. Verfahren nach Anspruch 1 oder 2, dadurch gekennzeichnet, daß in der aktiven Schicht (7) eine Ausstülpung (8, 10) erzeugt wird.

4. Verfahren nach Anspruch 1, dadurch gekennzeichnet, daß auf das Hilfssubstrat (3) eine Zwischenschicht (4), vorzugsweise aus Glaskeramik, aufgedruckt wird, wobei im Bereich der zu erzeugenden freitragenden Dickschichtstruktur ein Loch (5) ausgespart bleibt.

5. Verfahren nach Anspruch 4, dadurch gekennzeichnet, daß der Durchmesser (d) des Loches (5) etwa dem halben Durchmesser der später freitragend auszubildenden Dickschichtstruktur entspricht.

6. Verfahren nach Anspruch 4, dadurch gekennzeichnet, daß die Zwischenschicht (4) bei ca. 850° C in Luft eingebrannt wird.

7. Verfahren nach einem der Ansprüche 4 bis 6, dadurch gekennzeichnet, daß zwischen der aktiven Schicht (7) und der mit einem Loch (5) versehenen Zwischenschicht (4) ein Füllstoff (6) aufgedruckt wird.

8. Verfahren nach Anspruch 7, dadurch gekennzeichnet, daß der Außendurchmesser (dₐ) und damit die Außenkonturen der Füllstoffschicht (6) größer sind als diejenigen der aktiven Schicht (7).

9. Verfahren nach einem der vorhergehenden Ansprüche, dadurch gekennzeichnet, daß zum Verbinden mit der aktiven Schicht (7) das eigentliche Substrat (1) mit einer glashaltigen Paste (9) bedruckt wird.

10. Verfahren nach Anspruch 9, dadurch gekennzeichnet, daß das Substrat (1) mit der glashaltigen Paste (9), sei es naß, getrocknet oder gebrannt, auf das Hilfssubstrat (3) mit der aktiven Schicht (7) aufgelegt wird, wobei die Aussparung (2) in etwa zentrisch zur konkaven Ausstülpung liegt und danach gebrannt wird.

## Claims

1. Process for producing a thick-film structure on a substrate (1) over a recess (2) in this substrate (1), the active layer (7) initially being applied to an auxiliary substrate (3, 4, 6) and then being connected to the substrate (1) by firing, and the active layer (7) having a thermal expansion coefficient less than that of the substrate (1), with the result that an unsupported thick-film structure (10) is produced over the recess (2).

2. Process according to Claim 1, characterized in that a dielectric material which can be fired is used for the active layer (7), whereas the substrate (1) comprises ceramic, insulated high-temperature steel or glass.

3. Process according to Claim 1 or 2, characterized in that a protuberance (8, 10) is produced in the active layer (7).

4. Process according to Claim 1, characterized in that an intermediate layer (4), preferably made of glass ceramic, is printed onto the auxiliary substrate (3), a hole (5) remaining recessed in the region of the unsupported thick-film structure to be produced.

5. Process according to Claim 4, characterized in that the diameter (D) of the hole (5) corresponds to approximately half the diameter of the thick-film structure which is to be subsequently constructed in an unsupported manner.

6. Process according to Claim 4, characterized in that the intermediate layer (4) is fired at approximately 850°C in air.

7. Process according to one of Claims 4 to 6, characterized in that a filler (6) is printed on between the active layer (7) and the intermediate layer (4) provided with a hole (5).

8. Process according to Claim 7, characterized in that the outer diameter (dₐ) and hence the outer contours of the filler layer (6) are larger than those of the active layer (7).

9. Process according to one of the preceding claims, characterized in that a glass-containing paste (9) is printed onto the actual substrate (1), for the connection to the active layer (7).

10. Process according to Claim 9, characterized in that the substrate (1) with the glass-containing paste (9), which substrate may be wet, dry or fired, is placed onto the auxiliary substrate (3) with the active layer (7), the recess (2) being situated approximately centrally with respect to the concave protuberance, and is subsequently fired.

## Revendications

1. Procédé de fabrication d'une structure en couche épaisse sur un support (1) par-dessus une cavité (2) réalisée dans le support (1), selon lequel on applique la couche active (7) tout d'abord sur un support auxiliaire (3, 4, 6) puis on la relie au support (1) par combustion, la couche active (7) ayant un coefficient de dilatation thermique inférieur à celui du support (1) pour former au-dessus de la cavité (2) une structure en couche épaisse (10), autoportante.

2. Procédé selon la revendication 1, caractérisé en ce que pour la couche active (7) on utilise une matière diélectrique susceptible de brûler alors que le support (1) est en matière céramique, en acier très réfractaire, isolé, ou en verre.

3. Procédé selon la revendication 1 ou 2, caractérisé en ce qu'on crée une partie emboutie (8, 10) dans la couche active (7).

4. Procédé selon la revendication 1, caractérisé en ce que sur le support auxiliaire (3) on imprime une couche intermédiaire (4) de préférence en céramique de verre et au niveau de la structure en couche épaisse, autoportante, on laisse subsister un trou (5).

5. Procédé selon la revendication 4, caractérisé en ce que le diamètre (d) du trou (5) correspond sensiblement au demi-diamètre de la structure en couche épaisse, réalisée, qui sera autoportante.

6. Procédé selon la revendication 4, caractérisé en ce que la couche intermédiaire (4) est brûlée à l'air à une température d'environ 850°C.

7. Procédé selon l'une des revendications 4 à 6, caractérisé en ce qu'une matière de remplissage (6) est imprimée entre la couche active (7) et la couche intermédiaire (4) munie d'un orifice (5).

8. Procédé selon la revendication 7, caractérisé en ce que le diamètre extérieur (dₐ) et ainsi les contours extérieurs de la couche de matière de remplissage (6) sont plus grands que ceux de la couche active (7).

9. Procédé selon l'une des revendications précédentes, caractérisé en ce que pour relier la couche active (7) on imprime le support (1) proprement dit avec une pâte (9) contenant du verre.

10. Procédé selon la revendication 9, caractérisé en ce que le support (1) avec la pâte (9) contenant du verre, que cette pâte soit mouillée, séchée ou brûlée, est appliqué sur le support auxiliaire (3) avec la couche active (7) et la cavité (2) se situe sensiblement au milieu de la partie emboutie concave, puis on brûle.
